# EUROPEAN PATENT APPLICATION

(11) **EP 3 700 084 A1**
(43) Date of publication of application: **26.08.2020**
(21) Application number: 18868994.7
(22) Date of filing: 18.10.2018
(51) Int. Cl.: H02S 20/32, H02S 10/40, H01L 31/042, B63B 35/28, B63B 21/50, B63B 35/44

(54) **TRACKING-TYPE FLOATING SOLAR POWER GENERATION DEVICE**

(30) Priority: 18.10.2017 KR 20170135500
(71) Applicant: An, Seung-hyuk, Ganghwa-gun, Incheon 23000 (KR)
(72) Inventor: An, Seung-hyuk, Ganghwa-gun, Incheon 23000 (KR)
(74) Representative: M. Zardi & Co S.A.
(86) International application number: PCT/KR2018/012329
(87) International publication number: WO 2019/078637

(57) **Abstract**

The present invention discloses a tracking-type floating solar power generation device. The present invention provides the tracking-type floating solar power generation device, in which a central plate-shaped floating buoyancy central-axis member on which power conversion equipment is mounted is constructed in a barge form facilitating the fabrication of a structure and having secure durability through the continuous assembly of individual containers, a central buoyant part having a vertical stack structure is constructed under the floating buoyancy central-axis member, and outer buoyant parts which are separate from the floating buoyancy central-axis member outside the floating buoyancy central-axis member, which form multiple concentric circles, and on which solar modules are regularly seated are successively connected at constant intervals by maintaining bars and basic bars, thereby completing a floating solar light power plant that forms an independent island structure.

## Description

### Technical Field

The present invention relates generally to a solar power generation device using the inland water of a freshwater lake such as Soyang Dam, and more particularly to a tracking-type floating solar power generation device, in which a central plate-shaped floating buoyancy central-axis member on which power conversion equipment is mounted is constructed in a barge form facilitating the fabrication of a structure and having secure durability through the continuous assembly of individual containers, a central buoyant part having a vertical stack structure is constructed under the floating buoyancy central-axis member, and outer buoyant parts which are separate from the floating buoyancy central-axis member outside the floating buoyancy central-axis member, which form multiple concentric circles, and on which solar modules are regularly seated are successively connected at constant intervals by maintaining bars and basic bars, thereby completing a floating solar light power plant that forms an independent island structure, so that the solar modules seated on the central buoyant part and the outer buoyant parts track solar light while performing horizontal rotation movement and vertical movement on the surface of the water according to the altitude of the sun.

### Background Art

In general, solar batteries are photovoltaic cells that convert solar energy into electric energy. The application fields of such solar batteries are electric power sources for electronic clocks, radios, unmanned lighthouses, unmanned repeaters, buoy lights, satellites, rockets, etc.

Furthermore, houses for solar energy heating, fog warning lights that alert drivers when fog is on the road, and aircraft warning lights that are installed on structures such as a power transmission tower are also used as the application fields of solar batteries.

In connection with solar batteries used in these application fields, cells (each cell refers to one solar battery) are connected in series and parallel as many times as necessary to manufacture a solar panel, and such solar panels are connected and used in series and parallel as many times as necessary.

Meanwhile, this solar battery allows generated power to be directly used during the daytime for which sunlight can be received, but cannot generate power during the nighttime. Accordingly, in order to obtain and use power continuously, it is necessary to construct a circuit and to store power in an energy storage system (ESS) such as a NaS, RFB, or LiB battery, during the daytime and to use the power later.

In a conventional solar power generation device, a solar panel in which solar cells are connected in series and parallel as many times as necessary is fixedly installed at an angle of approximately 35 degrees toward a southward direction. The reason for this is to generate the maximum power by making the incident angle of solar light and the solar panel form a right angle in a fixed state.

However, in Korea, the altitude of the sun varies within the range of 12 to 58 degrees over seasons. Accordingly, when the solar panel is fixed, a problem arises in that power generation productivity is low and thus efficiency is low for invested cost.

Furthermore, in general, in order to generate solar power, solar panels are installed in large quantities on the land of several kilometers. There was a lot of difficulty in finding a suitable installation location due to the lack of land for the installation of numerous solar panels.

The large and flat land has a high land price, so it was difficult to purchase it for solar power generation. Furthermore, it is difficult to obtain a sunny place.

Accordingly, there have been attempts to install a solar power generation device on the water. However, there is a need for a device capable of generating solar power while varying with the flow and height of the surface of the water, and also there is a need for a method and structure for increasing the efficiency of solar power generation by changing the direction of the solar panel along the trajectory of the sunlight.

Accordingly, conventionally, as in Korean Patent No. 10-1013339 (published on February 10, 2011), there is disclosed a rotary floating solar power generation device, which is intended to use the empty surface of the water by installing a solar panel on the surface of the water without the need for a large area, which configures the solar panel so that it is rotated according to the trajectory of the sun in order to increase the efficiency of solar power generation, which when the solar panel is installed on the surface of the water, not only prevents the solar power generation device floating on the surface from floating, but also enables it to stably float even when the surface of the water rises or falls, which, in particular, is configured in a rotary form so that a buoy fastening frame onto which the solar panel is fastened can be braked at a correct location when it rotates along the sun, and which obtains driving force that enables easy rotation around a shaft column.

However, the prior patent described above is configured to set up the shaft column to the center and rotatably install an assembly around it. This method has a problem in that the shaft column is severely shaken due to external, environmental factors (e.g., a wind, a typhoon, etc.) and is broken in severe cases.

Furthermore, the prior patent described above is configured to construct the rotatable assembly on the single shaft column, and has a disadvantage in that the expansion of the solar panel is difficult.

### Disclosure

### Technical Problem

Accordingly, the present invention has been conceived to overcome the above-described conventional problems, and an object of the present invention is to provide a tracking-type floating solar power generation device, in which a central plate-shaped floating buoyancy central-axis member on which power conversion equipment is mounted is constructed in a barge form facilitating the fabrication of a structure and having secure durability through the continuous assembly of individual containers, a central buoyant part having a vertical stack structure is constructed under the floating buoyancy central-axis member, and outer buoyant parts which are separate from the floating buoyancy central-axis member outside the floating buoyancy central-axis member, which form multiple concentric circles, and on which solar modules are regularly seated are successively connected at constant intervals by maintaining bars and basic bars, thereby completing a floating solar light power plant that forms an independent island structure.

Another object of the present invention is to provide a tracking-type floating solar power generation device, in which solar modules seated on a central buoyant part and outer buoyant parts are configured to track solar light while performing horizontal rotation movement and vertical movement on the surface of the water according to the altitude of the sun by means of a waterwheel part, there stably maintaining the solar light power plant regardless of an external environment factor and increasing power generation efficiency.

Still another object of the present invention is to construct a spray propulsion nozzle configured such that the spraying location of an air jet is controlled through three- direction GPS location setting on outer buoyant parts forming multiple concentric circles and having solar modules, thereby enabling the outer buoyant parts forming multiple concentric circles to be rotated or easily move according to the sun.

Still another object of the present invention is to replace a spray propulsion nozzle with a propellant composed of a turbine-type drive device and to install a conveyor belt, from the surface of which a plurality of flaps protrudes successively, in a caterpillar structure to be fastened below an operator movement foot plate, thereby ensuring that the moving space of an operator is secured by removing unnecessary structures protruding upward and also effectively preventing the occurrence of reverse torque by generating propulsion force under the surface of the water.

Still another object of the present invention is to install an air or water supply device including a pump and/or a compressor and a spray tube on outer buoyant parts forming multiple concentric circles and having solar modules, thereby enabling a tracking-type floating solar power generation device to be stably maintained on the surface of the water and also facilitating the cooling of the solar modules or the removal of snow.

Still another object of the present invention is to, when a floating solar light power plant having an independent island structure is set as a large-capacity main power plant, locate small-capacity satellite power plants around the large-capacity main power plant and connect them with low-voltage underwater cables, so the power generated by the satellite power plants is transmitted to the main power plant at low voltage, and the transmitted power is boosted again by the main power plant and then transmitted to a power company, thereby increasing power generation efficiency.

### Technical Solution

In order to accomplish the above objects, the present invention provides a tracking-type floating solar power generation device including: a central barge part configured such that it is anchored by a plurality of anchors, containers in which first buoyant members are accommodated, respectively, are successively interconnected to each other so that power conversion equipment constituting a main power plant is mounted thereon, and perforated foot plates are placed on the successively connected containers, respectively; outer unit buoyant parts configured such that it is separated from the central barge part, forms concentric circles outside the barge part, and accommodates second buoyant members; and solar modules seated on the unit buoyant parts; thereby constituting an independent island structure; wherein the unit buoyant parts forming concentric circles along with the central barge part are successively interconnected at constant intervals by interval maintaining bars disposed in parallel and chains; wherein the unit buoyant parts are successively interconnected by basic bars disposed parallel with the interval maintaining bars and chains; wherein a first drive unit configured to be operated to horizontally rotate and move the central barge part and the unit buoyant parts on a surface of water according to a location of a sun between the unit buoyant parts for which an interval between the concentric circles is kept constant by the interval maintaining bars; wherein a second drive unit configured to be operated to adjust an inclined angle of the solar module according to an altitude of the sun is disposed on the basic bars; and wherein the first and second drive units are configured such that the operations thereof are controlled by a control unit configured to generate control signals for the tracking of solar light for each time zone based on the sunrise and sunset of the sun.

Connection rings are formed on the outer circumferential surfaces of the containers, first catch hooks configured to successively interconnect the containers are coupled around and fastened to the connection rings, mouths are formed on the top surfaces of the containers, coupling portions configured to surround the mouths are formed on the bottom surfaces of the perforated foot plates, fastening rings configured to fasten the perforated foot plates are coupled to top surfaces of the containers, and the perforated foot plates are connected and coupled to adjacent upper foot plates by second catch hooks.

The basic bars are constructed in a box-type structure to have a plurality of spaces in which second buoyant members are accommodated, connection rings configured such that the chains are coupled around them are disposed at both ends of the basic bars that constitute the box-type structure, and a first snap ring configured to be coupled around a corresponding one of the connection rings is disposed on any one of both ends of each of the chains.

A connection ring and a second snap ring are disposed on one end of each of the interval maintaining bars to be coupled around a corresponding one of the chains that connect the unit buoyant parts.

Inclined-angle setting bars for a concentric circle extension section are additionally disposed at a changed angle at same points along with the basic bars disposed in parallel with the interval maintaining bars, thereby providing a new angle parallel bar reference.

The first drive unit includes one or more first drive units that are disposed in a line between the unit buoyant parts that form the concentric circles.

According to one embodiment of the present invention, the first drive unit includes: a first motor configured to be rotated in a forward or reverse direction in response to a control signal of the control unit; and one or more waterwheels connected to the drive shaft of the first motor, and configured to be rotated in response to the forward or reverse rotation of the first motor in order to horizontally rotate the central barge part and the unit buoyant parts on the surface of the water according to the location of the sun.

Fixed frames through which the drive shaft pass are coupled over the interval maintaining bars, and the waterwheels are coupled over the drive shaft that passes through the fixed frames.

According to another embodiment of the present invention, the first drive unit is configured such that a conveyor belt from a surface of which a plurality of flaps protrudes successively is installed in a caterpillar structure to be fastened below an operator movement foot plate, thereby ensuring that the moving space of an operator is secured by removing unnecessary structures protruding upward and also effectively preventing the occurrence of reverse torque by generating propulsion force under the surface of the water.

The first drive unit formed in a shape of conveyor belts forming caterpillars has a fastening bracket configured to perform fastening under the operator movement foot plate while maintaining a predetermined distance, a plurality of cylindrical drums configured such that buoyancy thereof is adjustable through injection of air is disposed at lower ends of the fastening bracket, conveyor transfer protrusions protrude from a surface of the cylindrical drums, outsides of the cylindrical drums are surrounded with the conveyor belts, each of the conveyor belts is configured such that a plurality of connection plate members on which the individual flaps are disposed is spaced apart at predetermined intervals, and the spaced, adjacent connection plate members are combined by fastening rings, so that spaces in which the conveyor transfer protrusions formed on the surface of the cylindrical drum are placed are provided in connection portions of the fastening rings.

A forward/reverse rotation motor coupled to a drive gear and connected to a reducer through a transfer gear is disposed on one side of the center-of-rotation shaft of any one of the pair of cylindrical drums located both left and right ends.

An extension bracket is disposed at the lower end of the fastening bracket fastened under the operator movement foot plate and configured to support the plurality of cylindrical drums, and deflection preventing rollers are disposed on the lower ends of the extension bracket in order to prevent the downward deflection of a corresponding one of the conveyor belts each formed by connecting the plurality of connection plate members.

The individual flaps disposed outward on the surfaces of the conveyor belts are disposed to have a width smaller than that of the conveyor belts, and deflection preventing rollers are located in a flap-free section in which the individual flaps are not located in order to prevent downward deflection of the conveyor belts.

The second drive unit includes: a horizontal fastening part disposed on the basic bars; a vertical fastening part configured to connect the horizontal fastening part and a front side of each of the solar modules; a cylinder part coupled and fastened to the rear side of the horizontal fastening part; an angle adjusting bar connected to a moving element configured such that one end thereof is connected to the solar module and a remaining end thereof is accommodated inside the cylinder part and configured to adjust an inclined angle of the solar module while being selectively lifted and lowered by the moving element; and an altitude tracking buoyant element configured to be accommodated in a lower end of an inside of the cylinder part and to, when supply or discharge of water to or from the cylinder part is performed in response to a control signal of the control unit, be selectively lifted and lowered and selectively lift and lower the moving element.

The second drive unit includes: a horizontal fastening part disposed on the basic bars; an X bar configured to connect the horizontal fastening part and the solar module; and a second motor connected to a shaft connecting the X bar, and configured to be operated in response to a control signal of the control unit in order to adjust the inclined angle of the solar module by rotating the shaft.

The first and second buoyant members are configured to form concentric circles by binding a pair of binding strings to each buoyant member body and connecting the binding strings of the buoyant member bodies with connecting portions of adjacent buoyant member bodies in a bundle form; and the second buoyant member is constructed by arranging a plurality of concentric circles, formed by connecting a plurality of buoyant member bodies with the binding strings, at predetermined intervals and binding them with connecting rods radially arranged, first, second and third spray propulsion nozzles configured such that spraying of an air jet is controlled by valves through three-direction GPS location setting are constructed at ends of the connecting rods, and the third spray propulsion nozzle is configured to spray air in order to move the second buoyant member.

The binding strings are a pair of binding strings that form a ring shape, and the connection portions are connecting strings that are bound to the pair of binding strings forming a ring shape.

The binding strings are tied knot binding strings that are bound to the buoyant member bodies, and the connection portions are catch hooks that are formed when the tied knot binding strings are bound to the buoyant member bodies.

The buoyant member body is configured to have an internal column portion and an open top surface, the open top surface of the buoyant member body is configured to be covered with a cover, and binding grooves configured to allow the binding strings each forming a ring shape to be bound are formed in the cover and a bottom of the buoyant member body.

An air or water supply device including a pump and/or a compressor and a spray tube is disposed in the second buoyant member in order to spray air or seawater to cool the solar module or remove snow.

When a floating solar light power plant having an independent island structure is set as a large-capacity main power plant, small-capacity satellite power plants, each including a central barge part, unit buoyant parts, and solar modules, are located around the large-capacity main power plant and the large-capacity main power plant and the small-capacity satellite power plants are connected with low-voltage underwater cables.

The satellite power plants are configured to convert generated DC power into AC power through an inverter and then transmit it to the main power plant through underwater cables in a low-voltage state, and the main power plant is configured to boost the low-voltage AC power transmitted from the satellite power plants and then transmit it to a power company through a high-voltage underwater cable.

Anchors configured to fasten a location of a power plant against a typhoon or another situation are disposed on the central barge parts of the main power plant and the satellite power plants.

Each of the anchors is configured to be connected to a thick wire rope having a predetermined length and drooping to a floor, and the wire rope is configured to be bound to the central barge part in an emergency and to be connected to a thin lifting rope at a remaining end thereof during normal times to minimize water resistance while maintaining drooping.

Each of the plurality of anchors includes a plate-shaped fastening body formed by coupling a plurality of ring members based on connection bars radially connected to each other, a central weight insertion rod located at a center and a plurality of counterweight insertion rods spaced apart around the central weight insertion rod, which are installed to selectively couple a required number of weights, are installed to protrude upward along a surface of the fastening body, and bottom surface fastening wedge portions are formed on the bottoms of the central weight insertion rod and the counterweight insertion rods.

A basic frame is connected to the central barge part in a cross form, and the first buoyant members forming the concentric circles are successively disposed on the basic frame; auxiliary frames remaining at constant radial intervals are arranged between the basic frames forming concentric circles; and second buoyant members are disposed on the auxiliary frames.

A main supply tube for air or water supply configured to spray air or seawater in order to cooling the solar module or remove snow is disposed in each of the auxiliary frames.

A wire guide tube configured to guide an anchor cable is disposed on outsides of the containers containing the first buoyant members in order to maintain a stable buoyant posture of the central barge part; guide rollers are disposed at upper and lower ends of the wire guide tube; and a wire tension adjusting traction machine is disposed above the wire guide tube.

Upper and lower water tanks are successively disposed at a predetermined interval along a boundary surface of the central barge part and the unit buoyant parts disposed outside the barge part while forming concentric circles, the upper and lower water tanks are disposed to form a stack structure in which the upper and lower water tanks are disposed above and below a boundary surface of water of the central barge part and the unit buoyant parts disposed outside the barge part, and the upper and lower water tanks having respective shutoff valves are connected to a single circulation pipe and then connected to a plurality of altitude tracking cylinder parts; when the valve of the upper water tank is opened, the water of the upper water tank disposed above the surface of the water is discharged by natural water pressure and fills the cylinder part disposed on an outer side, and thus a slope of the solar module is adjusted to an erected state; and when the valve of the lower water tank is opened, the water filling the cylinder part is naturally discharged to the lower water tank located below the surface of the water, the water of the cylinder parts is discharged to the lower water tank, and thus the slope of the solar module is adjusted to a laid state.

In this case, the upper water tank is allowed to always remain in a filled state by installing a circulation pump to forcibly pump the water, discharged to the lower water tank, to the upper water tank, and stepwise tracking is enabled by allowing the valves of the upper and lower water tanks to be opened on a predetermined time unit basis through integrated control.

The water discharged to the lower water tank is forcibly pumped to the upper water tank by the circulation pump so that the upper water tank always remains in a filled state.

### Advantageous Effects

As described above, the present invention provides the tracking-type floating solar power generation device, in which a central plate-shaped floating buoyancy central-axis member on which power conversion equipment is mounted is constructed in a barge form facilitating the fabrication of a structure and having secure durability through the continuous assembly of individual containers, a central buoyant part having a vertical stack structure is constructed under the floating buoyancy central-axis member, and outer buoyant parts which are separate from the floating buoyancy central-axis member outside the floating buoyancy central-axis member, which form multiple concentric circles, and on which solar modules are regularly seated are successively connected at constant intervals by maintaining bars and basic bars, thereby completing a floating solar light power plant that forms an independent island structure, via which an effect is expected in that the solar modules seated on the central buoyant part and the outer buoyant parts can stably maintain the solar light power plant regardless of an external environment factor and increase power generation efficiency while tracking solar light while performing horizontal rotation movement and vertical movement on the surface of the water according to the altitude of the sun.

The effects of the present invention are not limited to that mentioned above, and other effects that are not mentioned will be clearly understood by those skilled in the art from the descriptions of the claims.

### Description of Drawings

FIG. 1 is a schematic plan view showing the overall structure of a tracking-type floating solar power generation device according to an embodiment of the present invention;
FIG. 2 is a schematic front view showing the overall structure of the tracking-type floating solar power generation device according to the embodiment of the present invention;
FIG. 3 is an enlarged view of part of the overall structure of the tracking-type floating solar power generation device according to the embodiment of the present invention;
FIG. 4 is an exploded perspective view showing the structure of a unit buoyant part according to an embodiment of the present invention;
FIG. 5 is a schematic plan view showing the structure of the unit buoyant part according to the embodiment of the present invention;
FIG. 6 is a plan view of a central barge part for installation in a substation according to an embodiment of the present invention;
FIG. 7 is an enlarged view of portion "A" of FIG. 6 according to an embodiment of the present invention;
FIG. 8 is an exploded perspective view of a central barge part according to an embodiment of the present invention;
FIG. 9 is a schematic sectional view of the central barge part according to the embodiment of the present invention;
FIG. 10 is a side view showing the concept of sun altitude tracking according to an embodiment of the present invention;
FIG. 11 is a plan view showing the concept of sun altitude tracking according to the embodiment of the present invention;
FIGS. 12(a) to 12(e) are views showing the stepwise operating states of the altitude tracking of a solar module based on the operation of a second drive unit according to an embodiment of the present invention;
FIG. 13 is a schematic plan view of a floating buoyant structure showing a state of supplying or discharging water to and from an altitude tracking cylinder part according to an embodiment of the present invention;
FIG. 14 is a schematic side sectional view showing a state of supplying or discharging water to and from an altitude tracking cylinder part using upper and lower water tanks according to the embodiment of the present invention;
FIG. 15 is a plan view showing the structure of an improved anchor according to the present invention;
FIG. 16 is a front view showing the structure of the improved anchor according to the present invention;
FIG. 17 is a schematic plan view of a first drive unit according to an embodiment of the present invention;
FIG. 18 is a schematic side view of the first drive unit according to the embodiment of the present invention;
FIG. 19 is a plan view schematically showing a location at which the first drive unit is installed according to the present invention;
FIG. 20 is a schematic side view of a first drive unit according to another embodiment of the present invention;
FIG. 21 is a schematic front view of the first drive unit according to another embodiment of the present invention;
FIG. 22 is a schematic plan view of the first drive unit according to another embodiment of the present invention;
FIGS. 23(a) to 23(c) are views showing the stepwise operation states of the rotation of a floating solar power generation device by a first drive unit according to an embodiment of the present invention;
FIG. 24 is a view of a second drive unit according to another embodiment of the present invention;
FIG. 25 is a schematic plan view showing a state in which small-capacity satellite power plants are connected to a large-capacity main power plant by low-voltage underwater cables according to another embodiment of the present invention;
FIG. 26 is a perspective view showing the structure of a first buoyant member according to still another embodiment of the present invention;
FIG. 27 is a perspective view showing the structure of a second buoyant member according to still another embodiment of the present invention;
FIG. 28 is a schematic sectional view showing the structure of the second buoyant member according to still another embodiment of the present invention;
FIG. 29 is a perspective view showing a state in which the buoyant member bodies of second buoyant members are connected by tied knot catch strings and catch hooks according to still another embodiment of the present invention;
FIG. 30 is a schematic plan view of the structure of a tracking-type floating solar power generation device according to still another embodiment of the present invention;
FIG. 31 is an enlarged view of a part of FIG. 30 according to still another embodiment of the present invention;
FIG. 32 is a schematic front view of FIG. 31 according to still another embodiment of the present invention;
FIG. 33 is a schematic plan view showing the structure of a tracking-type floating solar power generation device according to still another embodiment of the present invention;
FIG. 34 is a schematic perspective view showing the connection state of a central barge part and a basic frame according to still another embodiment of the present invention;
FIG. 35 is a schematic perspective view showing a state in which a solar module is installed on an assembly formed by connecting a central barge part and a basic frame according to still another embodiment of the present invention;
FIG. 36 is an enlarged perspective view of a part of a main power plant in which a solar module is installed according to still another embodiment of the present invention;
FIG. 37 shows a perspective view, a plan view and a side sectional view showing the structure of a first buoyant member according to still another embodiment of the present invention;
FIG. 38 shows a perspective view, a plan view and a side sectional view showing the structure of a second buoyant member according to still another embodiment of the present invention; and
FIG. 39 is a perspective view showing a state in which a solar module is cooled or snow is removed via a main supply tube for air or water supply installed on an auxiliary frame according to still another embodiment of the present invention.

### Mode for Invention

Embodiments of the present invention will be described in detail below with reference to the accompanying drawings.

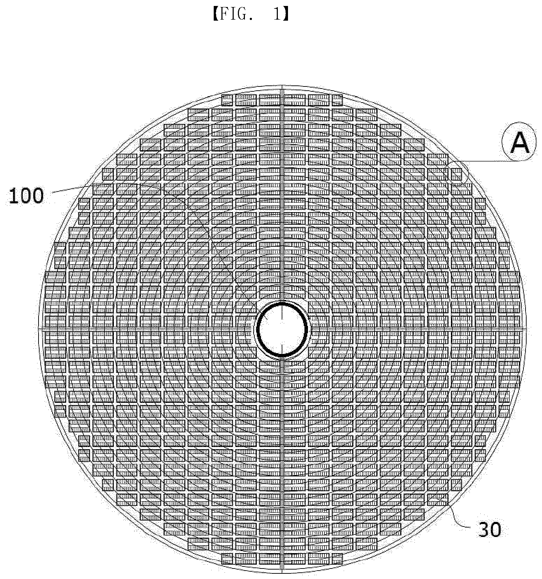

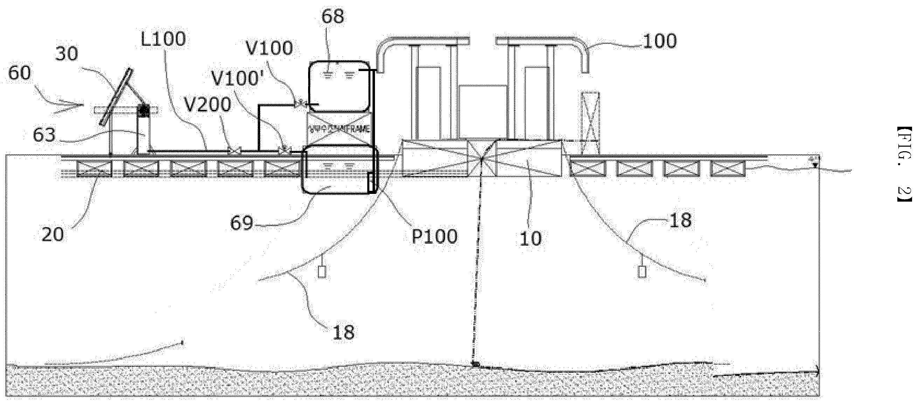

Referring to the accompanying FIGS. 1 to 9, a tracking-type floating solar power generation device according to an embodiment of the present invention is configured to include a central barge part 10, outer unit buoyant parts 20, solar modules 30, interval maintaining bars 40, first and second drive units 50 and 60, and a control unit 70.

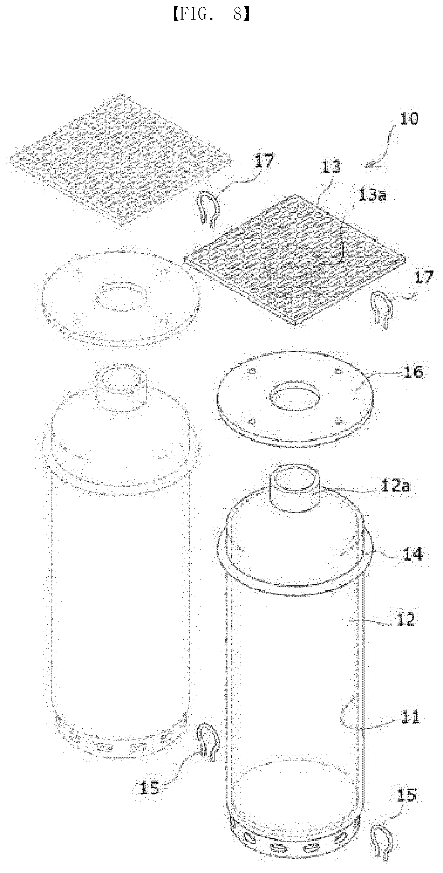

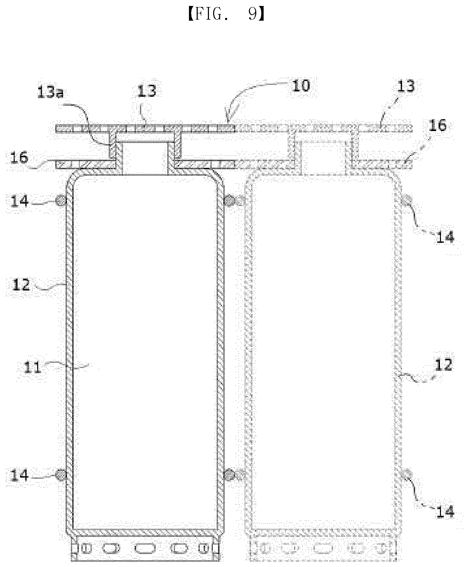

The central barge part 10 may be anchored with a plurality of anchors 180. As shown in the accompanying FIGS. 8 and 9, containers 12 configured to accommodate first buoyant members 11, respectively, are interconnected on the top of the central barge part 10, and perforated foot plates 13 are placed on the containers 12 so that power conversion equipment 100 constituting a main power plant M can be mounted thereon.

In this case, connection rings 14 are formed on the outer circumferential surfaces of the containers 12, first catch hooks 15 configured to interconnect the containers 12 to each other are caught on and fastened to the connection rings 14, mouths 12a are formed on the tops of the containers 12, coupling portions 13a configured to surround the mouths 12a are formed on the bottoms of the perforated foot plates 13, fastening rings 16 configured to fasten the perforated foot plates 13 are fitted into the tops of the containers 12, and the perforated foot plates 13 are connected and fastened to adjacent upper foot plates by second catch hooks 17.

In other words, the central barge part 10 is configured to provide a space, on which the power conversion equipment 100 is placed, by connecting the containers 12 accommodating the first buoyant members 11 with the connection rings 14 and the first catch hooks 15 in the state in which the first buoyant members 11 have been accommodated inside the containers 12, coupling the fastening rings 16 and the perforated foot plates 13 to the upper ends of the containers 12, and also connecting these with the second catch hooks 17.

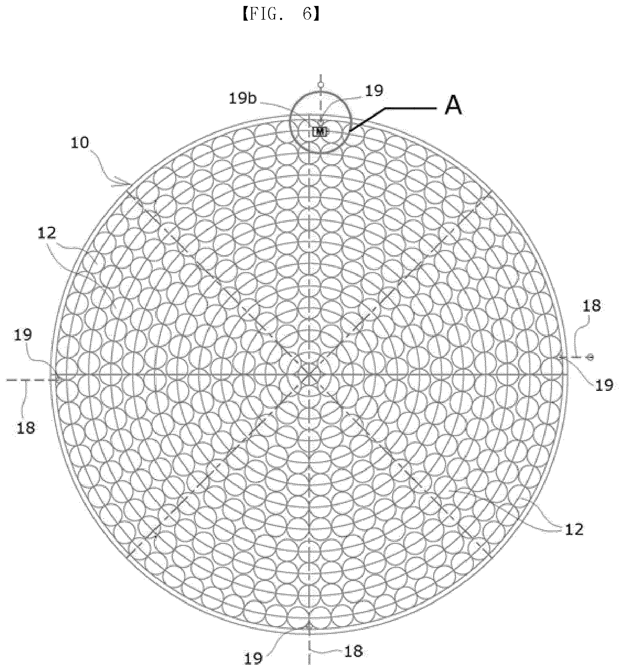

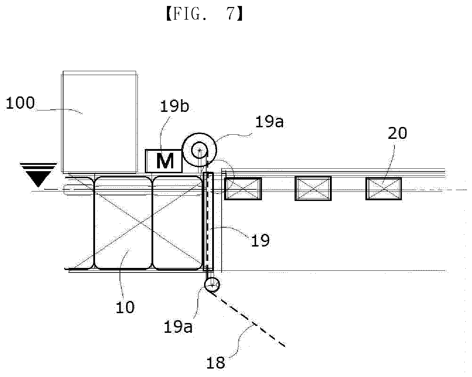

Meanwhile, as shown in the accompanying FIG. 6 and FIG. 7, a wire guide tube 19 configured to guide an anchor cable 18 is disposed on the outsides of the containers 12 containing the first buoyant members 11, guide rollers 19a are disposed at the upper and lower ends of the wire guide tube 19, a wire tension adjusting traction machine 19b is disposed above the wire guide tube 19, and the stable buoyant posture of the central barge part 10 may be maintained through the adjustment of the tension of the anchor cable 18 by the traction machine 19b.

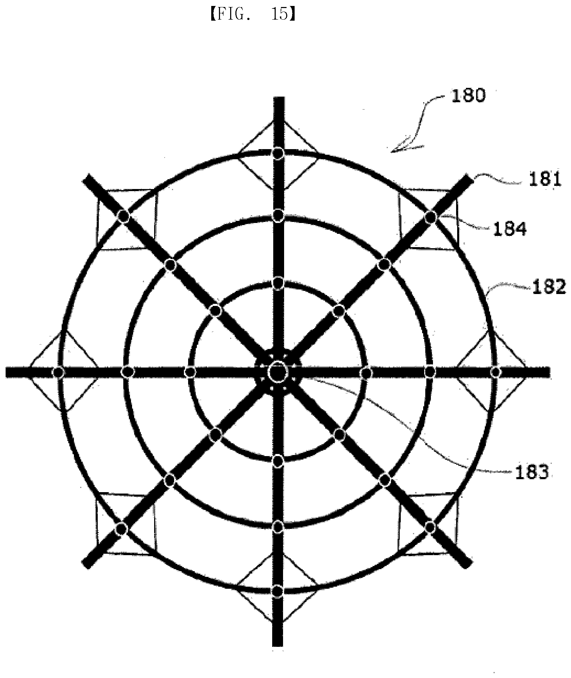

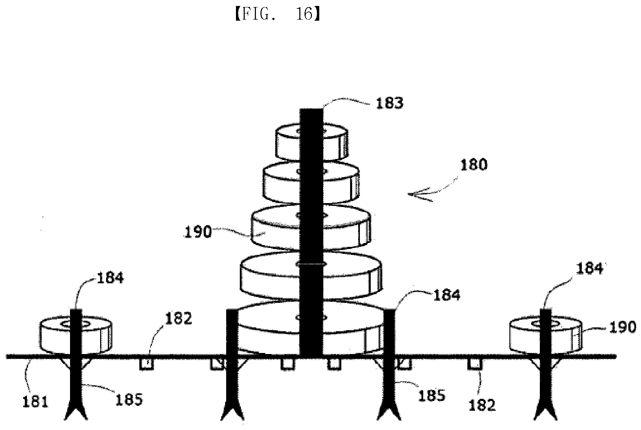

Meanwhile, as exemplarily shown in the accompanying FIGS. 15 and 16, each of the plurality of anchors 180 used to anchor the central barge part 10 may include a plate-shaped fastening body formed by coupling a plurality of ring members 182 based on connection bars 181 that are radially connected to each other. A central weight insertion rod 183 located at the center and a plurality of counterweight insertion rods 184 spaced apart around the central weight insertion rod 183, which are installed to selectively couple a required number of weights 190, are installed to protrude upward along the surface of the fastening body, and bottom surface fastening wedge portions 185 are formed on the bottoms of the central weight insertion rod 183 and the counterweight insertion rods 184.

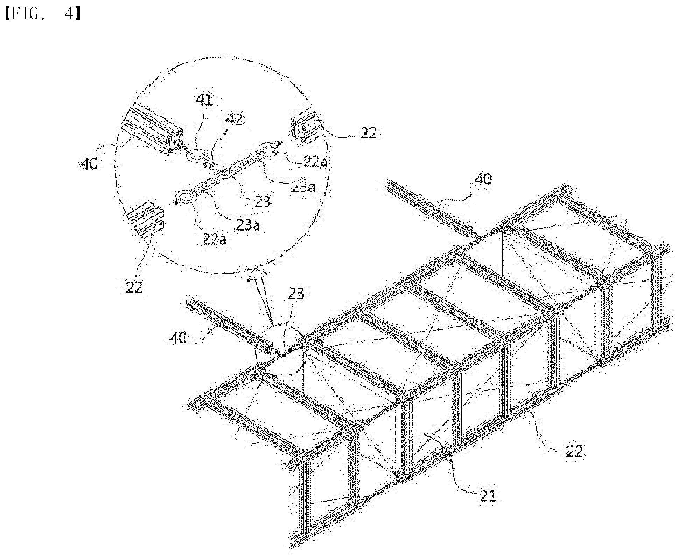

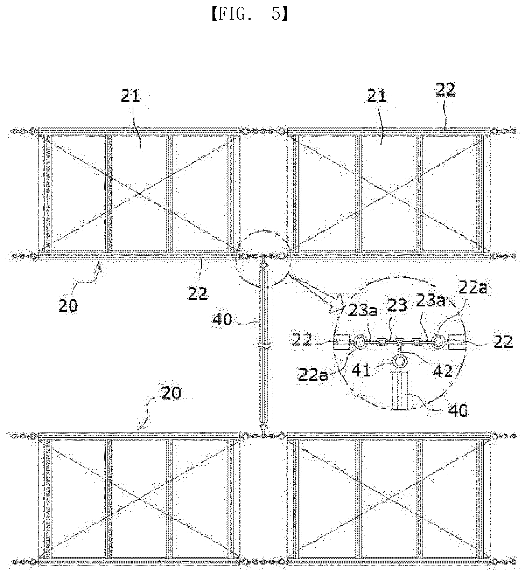

As shown in the accompanying FIGS. 4 and 5, the unit buoyant parts 20 are separated from the central barge part 10, and are successively disposed while forming concentric circles around the barge part 10. The unit buoyant parts 20 are successively interconnected to each other via basic bars 22 in which second buoyant members 21 are accommodated and chains 23.

The second buoyant member 21 that forms the unit buoyant part 20 is usually formed in a hollow parallelepiped box shape. Although the second buoyant member 21 is not limited to a specific material, plastic foam, a synthetic resin container or the like may be generally used as the second buoyant member 21 in order to provide corrosion resistance and maintain the best buoyancy. More preferably, the durability of the second buoyant member 21 may be maintained by installing a plurality of predetermined partitions therein.

Meanwhile, the basic bars 22 form a box-type structure so that there is provided a plurality of spaces in which the second buoyant members 21 are accommodated. Connection rings 22a configured such that the chain 23 is fastened thereto are formed at both ends of the basic bars 22 that form the box-type structure, and a first snap ring 23a coupled around the connection ring 22a is formed at any one of both ends of the chain 23.

The solar modules 30 are seated on the unit buoyant parts 20. Accordingly, the central barge part 10, the unit buoyant parts 20, and the solar modules 30 may constitute one independent island structure according to their coupled state.

In other words, the unit buoyant parts 20 successively disposed outside the central barge part 10 while forming concentric circles and the solar modules 40 seated on the unit buoyant parts 20 constitute the large-capacity main power plant M that forms one independent island structure.

Both ends of each of the interval maintaining bars 40 are connected and fastened to a corresponding one of the chains 23 connecting the basic bars 22, i.e., a box-type structure, so that the basic bars 22 constituting the unit buoyant parts 20 can keep the interval between concentric circles constant.

Accordingly, a connection ring 41 and a second snap ring 42 are formed at one end of each of the interval maintaining bars 40 to be coupled around a corresponding one of the chains 23 that connect the unit buoyant parts 20.

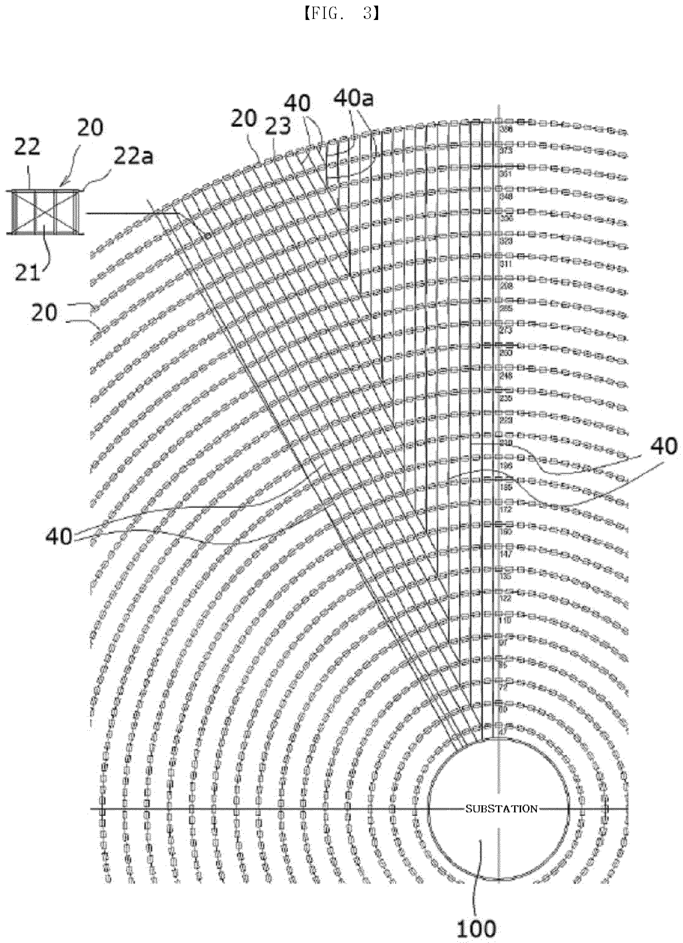

Meanwhile, as shown in the accompanying FIG. 3, inclined-angle setting bars 40a for a concentric circle extension section may be further provided. The inclined-angle setting bars 40a for a concentric circle extension section are additionally disposed at a changed angle at the same points along with the basic bars 22 disposed in parallel with the interval maintaining bars 40, thereby providing a new angle parallel bar reference.

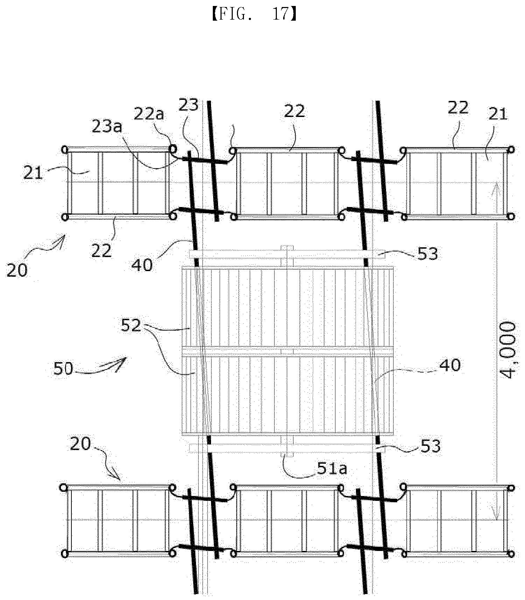

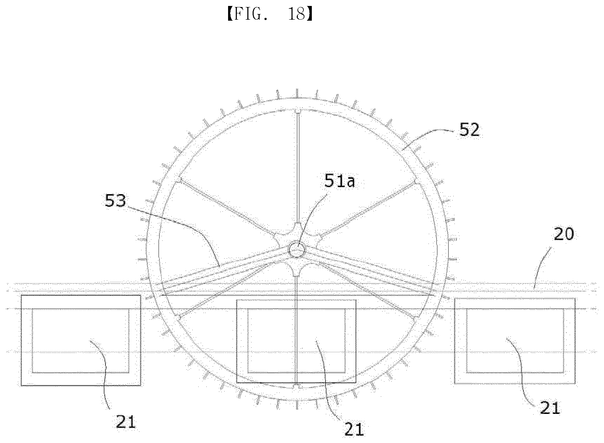

As shown in the accompanying FIGS. 17 and 18, as an embodiment, the first drive unit 50 is coupled between the unit buoyant parts 20 for which the interval between the concentric circles is kept constant by the interval maintaining bar 40. The first drive unit 50 is operated to horizontally rotate the central barge part 10 and the unit buoyant parts 20 on the surface of the water according to the location of the sun. One or more first drive units 50 are disposed in a line between the unit buoyant parts 20 that form concentric circles.

In this case, the first drive unit 50 illustrated in FIGS. 17 and 18 is configured to include a first motor 51 configured to be rotated in a forward or reverse direction in response to a control signal of the control unit 70, and one or more waterwheels 52 connected to the drive shaft 51a of the first motor 51, and configured to be rotated in response to the forward or reverse rotation of the first motor 51 in order to horizontally rotate the central barge part 10 and the unit buoyant parts 20 on the surface of the water according to the location of the sun.

In this case, fixed frames 53 through which the drive shaft 51a pass are coupled over the interval maintaining bars 40 that keep the interval between the concentric circles of the basic bars 22 constant, and the waterwheels 52 are coupled over the drive shaft 51a that passes through the fixed frames 53.

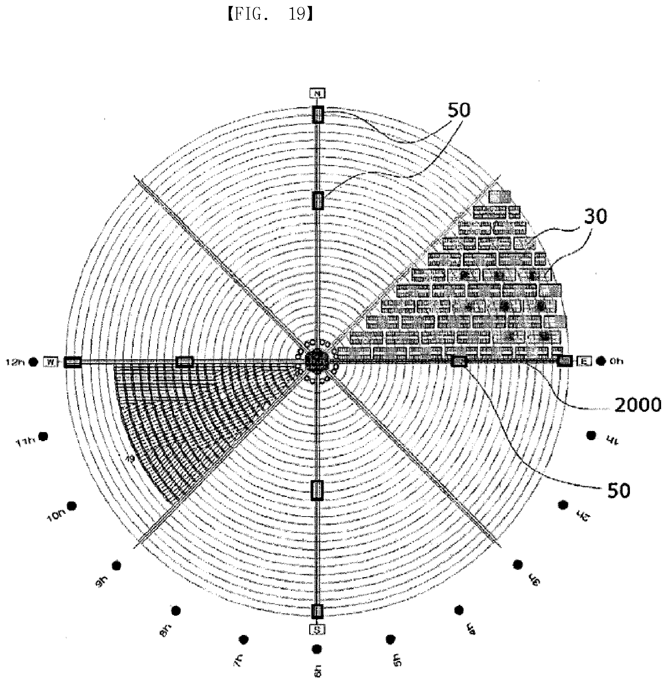

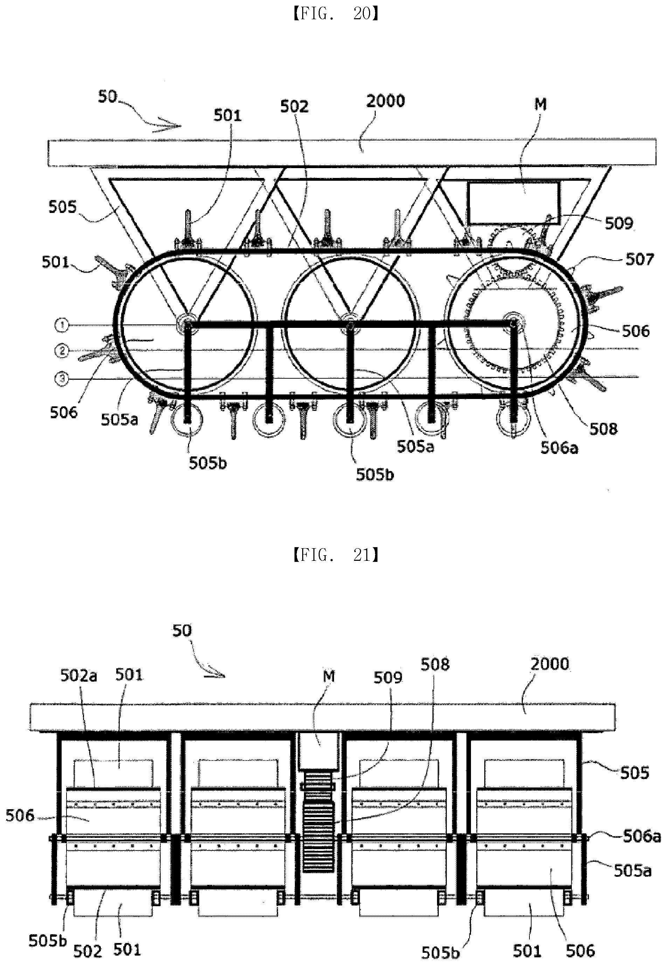

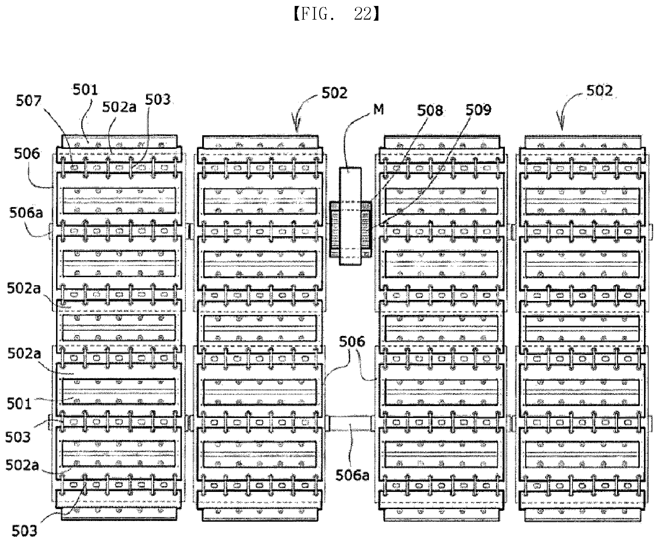

More preferably, as shown in FIGS. 19 to 22, the first drive unit 50 is configured such that a conveyor belt 502 from the surface of which a plurality of flaps 501 protrudes successively may be installed in a caterpillar structure to be fastened below an operator movement foot plate (not shown). The reason for this is to ensure that the moving space of an operator is secured by removing unnecessary structures protruding upward and also to effectively prevent the occurrence of reverse torque by generating propulsion force under the surface of the water.

In other words, the first drive unit 50 formed in the shape of the conveyor belts 502 forming caterpillars has a fastening bracket 505 configured to perform fastening under the operator movement foot plate while maintaining a predetermined distance. A plurality of cylindrical drums 506 configured such that the buoyancy thereof is adjustable through the injection of air is disposed at lower ends of the fastening bracket 505. Conveyor transfer protrusions 507 protrude from the surface of the cylindrical drums 506, and the outsides of the cylindrical drums 506 are surrounded with the conveyor belts 502. Each of the conveyor belts 502 is configured such that a plurality of connection plate members 502a on which the individual flaps 501 are disposed is spaced apart at predetermined intervals, and the spaced, adjacent connection plate members 502a are combined by fastening rings 503, so that spaces in which the conveyor transfer protrusions 507 formed on the surface of the cylindrical drum 506 are placed are provided in the connection portions of the fastening rings 503.

In this case, a forward/reverse rotation motor M coupled to a drive gear 508 and connected to a reducer through the transfer gear 509 is disposed on one side of the center-of-rotation shaft 506a of any one of the pair of cylindrical drums 506 located both left and right ends.

An extension bracket 505a is disposed at the lower end of the fastening bracket 505 fastened under the operator movement foot plate and configured to support the plurality of cylindrical drums 506, and deflection preventing rollers 505b are disposed on the lower ends of the extension bracket 505a in order to prevent the downward deflection of a corresponding one of the conveyor belts 502 each formed by connecting the plurality of connection plate members 502a.

The individual flaps 501 disposed outward on the surfaces of the conveyor belts 502 are disposed to have a width smaller than that of the conveyor belts 502, and the deflection preventing rollers 505b are located in a flap-free section in which the individual flaps 501 are not located in order to prevent the downward deflection of the conveyor belts 502.

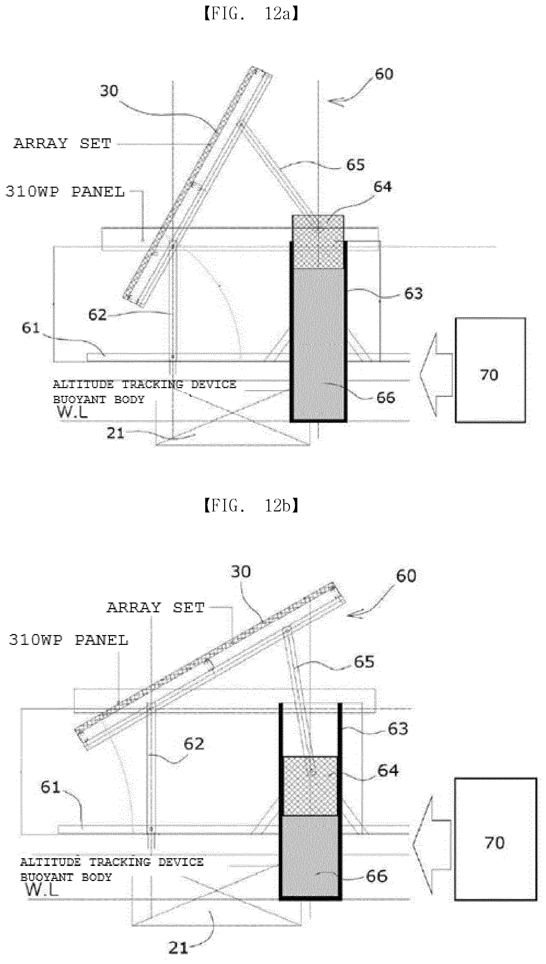

As shown in the accompanying FIGS. 12(a) to 12(e) to FIG. 14, the second drive unit 60 is formed on the basic bars 22, is operated to adjust the inclined angle of the solar modules 30 according to the altitude of the sun, and is configured to include a horizontal fastening part 61 disposed on the basic bars 22, a vertical fastening part 62 configured to connect the horizontal fastening part 61 and the front side of each of the solar modules 30, a cylinder part 63 coupled and fastened to the rear side of the horizontal fastening part 61, an angle adjusting bar 65 connected to a moving element 64 configured such that one end thereof is connected to the solar module 30 and the other end thereof is accommodated inside the cylinder part 63 and configured to adjust the inclined angle of the solar module 20 while being selectively lifted and lowered by the moving element 64, and an altitude tracking buoyant element 66 configured to be accommodated in the lower end of the inside of the cylinder part 63 and to, when the supply or discharge of water to or from the cylinder part 63 is performed in response to a control signal of the control unit 70, be selectively lifted and lowered and selectively lift and lower the moving element 64.

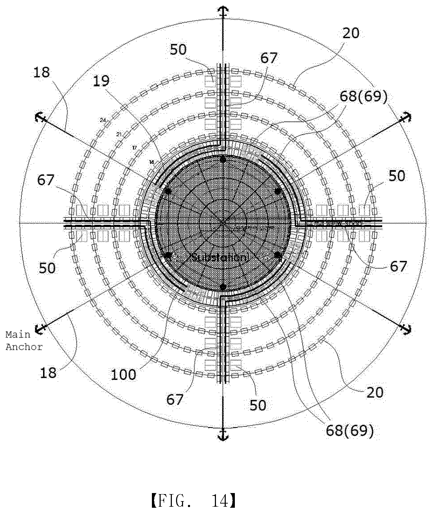

In this case, a water supply pipe and a water discharge pipe for the control of the altitude tracking buoyant element 66 illustrated in the accompanying FIGS. 12(a) to 12(e) are adapted to use a water supply and discharge control method using a single pipe 67, as shown in the accompanying FIG. 13.

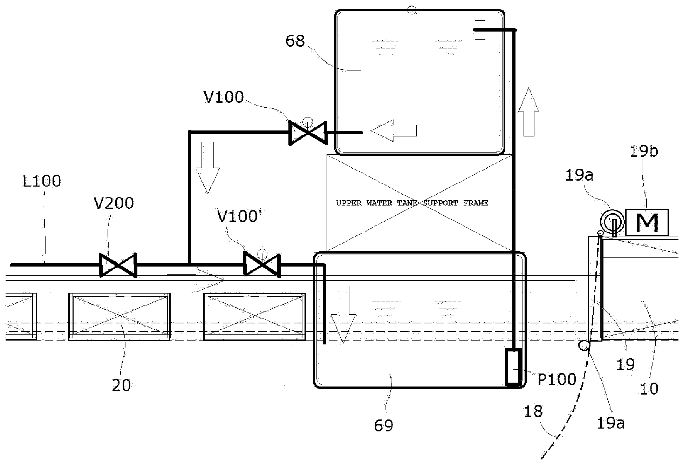

In other words, upper and lower water tanks 68 and 69 are successively disposed at a predetermined interval along the boundary surface of the central barge part 10 and the unit buoyant parts 20 disposed outside the barge part 10 while forming concentric circles. The upper water tank 68 and the lower water tank 69 are disposed to be connected by the single pipe 67. As shown in the accompanying FIG. 14, there is provided an installation structure in which the upper and lower water tanks 68 and 69 are disposed above and below the boundary surface of the water of the central barge part 10 and the unit buoyant parts 20 disposed outside the barge part 10.

In this case, although the upper and lower water tanks 68 and 69 have independent shutoff valves V100 and V100', they are connected to a single circulation pipe L100 and connected to a plurality of altitude tracking cylinder parts 63.

In other words, the upper and lower water tanks 68 and 69 have the respective shutoff valves V100 in the circulation pipes L100 connected to the sides of the upper and lower water tanks 68 and 69. Accordingly, when the valve V100 of the upper water tank 68 is opened, the water of the upper water tank 68 disposed above the surface of the water is discharged by natural water pressure, and the cylinder part 63 disposed on the outer side is filled with water. Accordingly, the slope of the solar modules 30 may be adjusted to the slopes of the respective steps shown in the accompanying FIGS. 12(a) to 12(e).

In this case, the valve V100' of the lower water tank 69 needs to remain in a closed state. The reason for this is to direct the water discharge from the upper water tank 68 only in the direction of the cylinder parts 63.

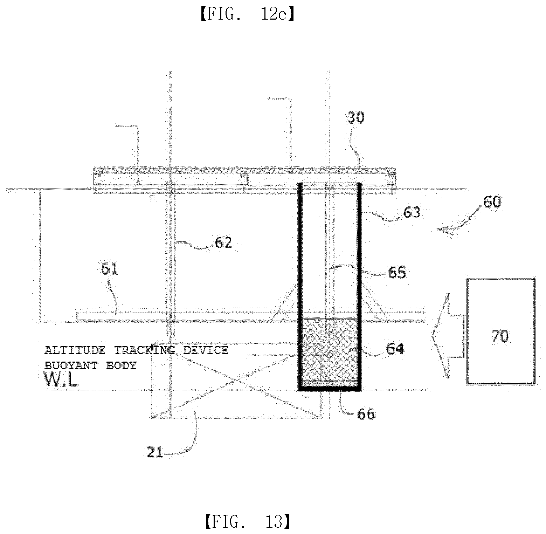

Meanwhile, when the water discharge from the upper water tank 68 reaches the upper ends of the cylinder parts 63 and thus the slope of the solar module 30 reaches the location of FIG. 12(a), the valve V100' of the lower water tank 69 is opened, and thus the water with which the cylinder parts 63 are filled is naturally discharged to the lower water tank 69 located below the surface of the water. Accordingly, the water of the cylinder parts 63 is discharged to the lower water tank 69, and thus the slope of the solar module 30 is changed from the location of the accompanying FIG. 12(b) to the location of FIG. 12(e).

In this case, the upper water tank 68 is allowed to remain in a filled state by installing a circulation pump P100 to forcibly pump the water, discharged to the lower water tank 69, to the upper water tank 68. Stepwise tracking is enabled by opening the valves V100 and V100' of the upper and lower water tanks 68 and 69 at predetermined time intervals through integrated control.

Meanwhile, as another embodiment of the present invention, one integrated valve V200 may be disposed on the outer side of the circulation pipe L100 in which the valves V100 and V100' of the upper and lower water tanks 68 and 69 are disposed. In this case, in the state in which all the lower water tanks 69 are closed and all the upper water tanks 68 are opened, control may be performed using the integrated valve V200 so that the water discharge from the upper water tank 68 is supplied to the cylinder part 63 in a stepwise manner. This provides advantages in that the above-described integrated valve V200 facilitates time control and the same control using the integrated valve V200 is enabled for recovery to the lower water tank 69.

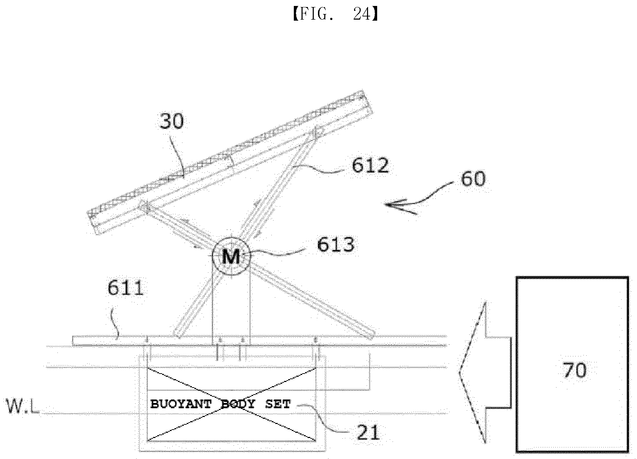

Meanwhile, as another embodiment of the second drive unit 60, as shown in the accompanying FIG. 24, the second drive unit 60 may be configured to include a horizontal fastening part 611 disposed on the basic bars 22, an X bar 612 configured to connect the horizontal fastening part 611 and the solar module 30; and a second motor 613 connected to a shaft connecting the X bar 612 and configured to be operated in response to a control signal of the control unit 70 in order to adjust the inclined angle of the solar module 30 by rotating the shaft.

The control unit 70 is configured to generate control signals for the tracking of solar light for each time zone based on the sunrise and sunset of the sun, and then outputs them to the first and second drive units 50 and 60, respectively. Although the control unit 70 may be constructed in the central barge portion 10, it may be remotely controlled from a remote location so as to be connected to the first and second drive units 50 and 60 over a communication network.

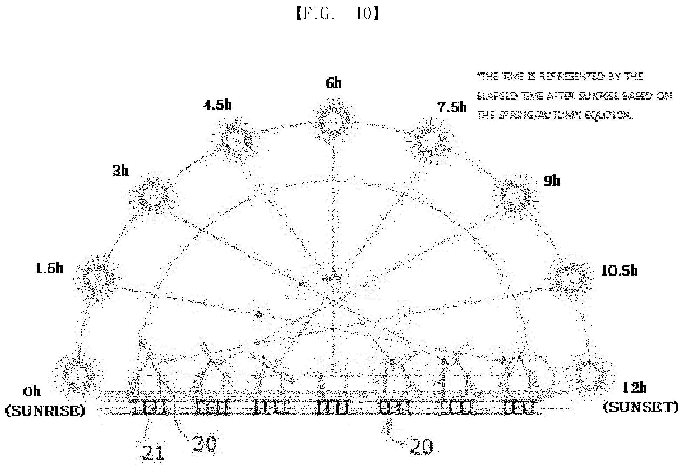

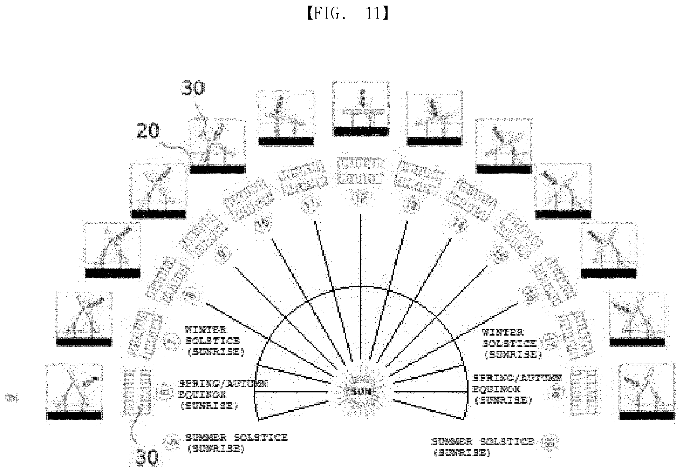

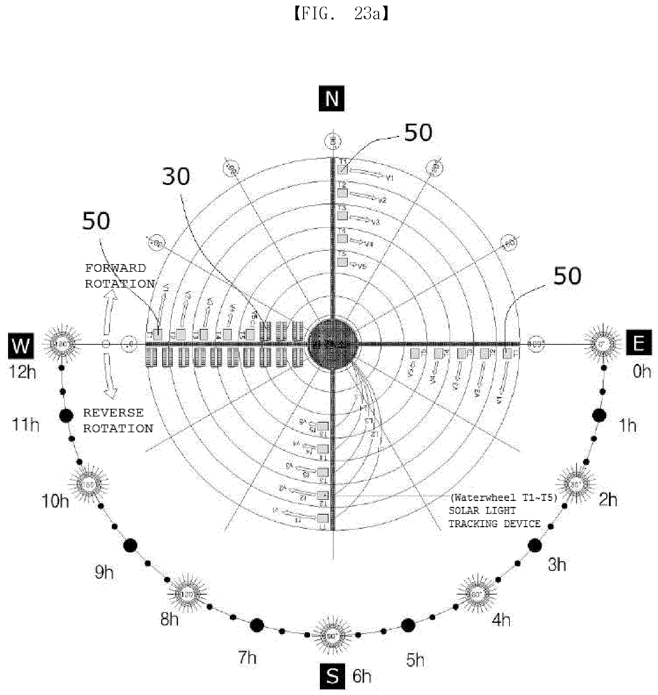

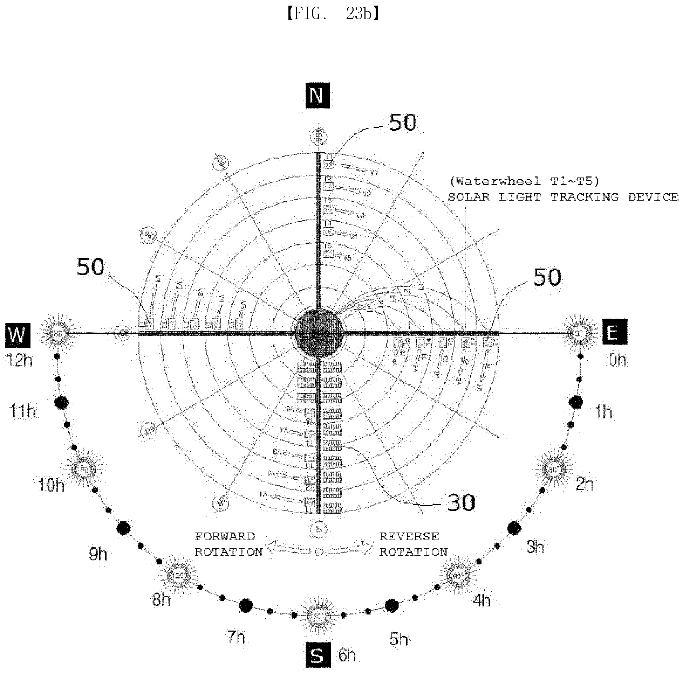

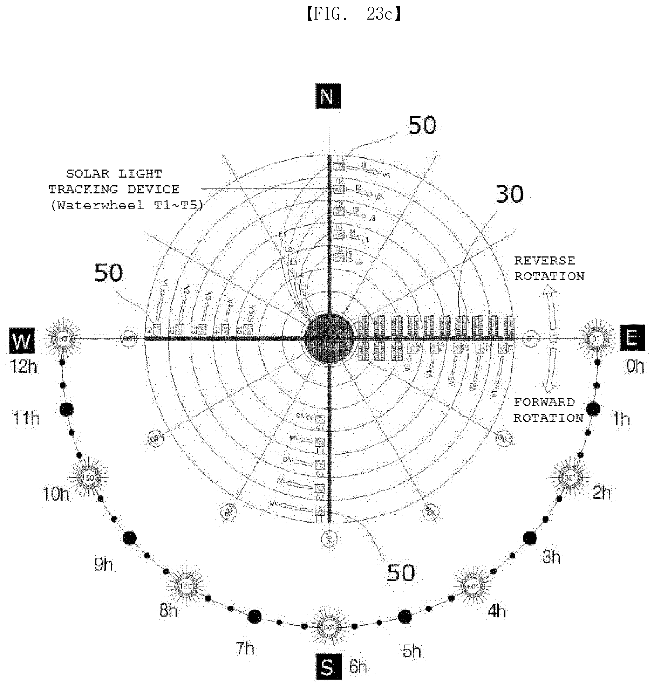

In the tracking-type floating solar power generation device according to an embodiment of the present invention, which is configured as described above, connection rings 14 are first formed on containers 12 into which first buoyant members 11 are introduced, and the connection rings 14 are connected with first catch hooks 15, as shown in the accompanying FIGS. 1 to 24.

Next, the fastening rings 16 are coupled to the upper ends of the containers 12, perforated foot plates 13 are coupled to the mouths 12a of the upper ends of the containers 12, and the perforated foot plates 13 are successively connected by the second catch hooks 17, there constructing a central barge part 10.

Next, unit buoyant parts 20 forming multiple concentric circles are constructed outside the central barge part 10 by locating basic bars 22, i.e., a box-type structure, connected using chains 23 outside the central barge part 10.

Thereafter, in the state in which the concentric circles of the unit buoyant parts 20 are maintained at a constant interval by connecting interval maintaining bars 40 to the chains 23 configured to connect the unit buoyant parts 20 that form multiple concentric circles, power conversion equipment 100 is mounted on the central barge part 10, a first drive unit 50 is coupled between the unit buoyant parts 20, a second drive unit 60 is coupled to the unit buoyant part 20, and solar modules 30 are coupled to the second drive unit 60, thereby completing a large-capacity main power plant M that constitutes one independent island structure.

In this case, in the main power plant M constituting an independent island structure as described above, the control unit 70 generates control signals for the tracking of solar light for each time zone based on the sunrise and sunset of the sun, and then outputs them to the first and second drive units 50 and 60. Waterwheels 52 included in the first drive unit 50 are rotated by the operation of the first motor 51, and allows the main power plant M constituting one independent island structure to be horizontally rotated on the surface of the water, as shown in the accompanying FIG. 24.

Meanwhile, an altitude tracking buoyant element 66 included in the second drive unit 60 is lowered to the upper end of a cylinder part 63 as a fluid is supplied, a moving element 64 is lowered in conjunction with the lowering of the altitude tracking buoyant element 66, and an angle adjusting bar 65 coupled to the moving element 64 is introduced into the cylinder part 63.

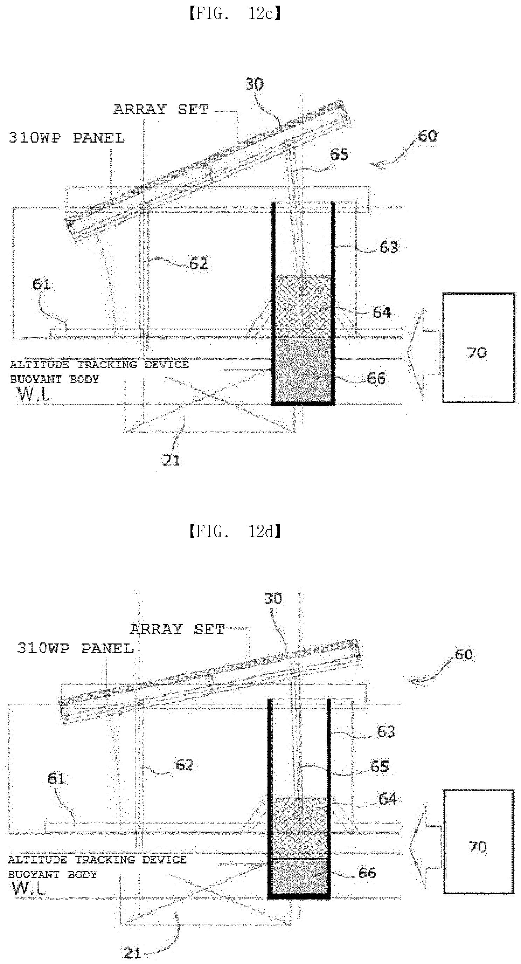

Then, as a solar module 30 connected to the angle adjustment bar 65 by a hinge is rotated in the order of (a) → (b) → (c) → (d) → (e) in FIG. 12 and laid down horizontally, the solar module 30 may collect solar light until the sun is at sunset.

In this case, although not shown in the drawings, DC power generated by tracking the altitude of the sun through the driving of the first and second drive units 50 and 60 and collecting solar light using the solar modules 30 is converted into AC power by power conversion equipment 100, and is transmitted to a power company through a high-voltage underwater cable.

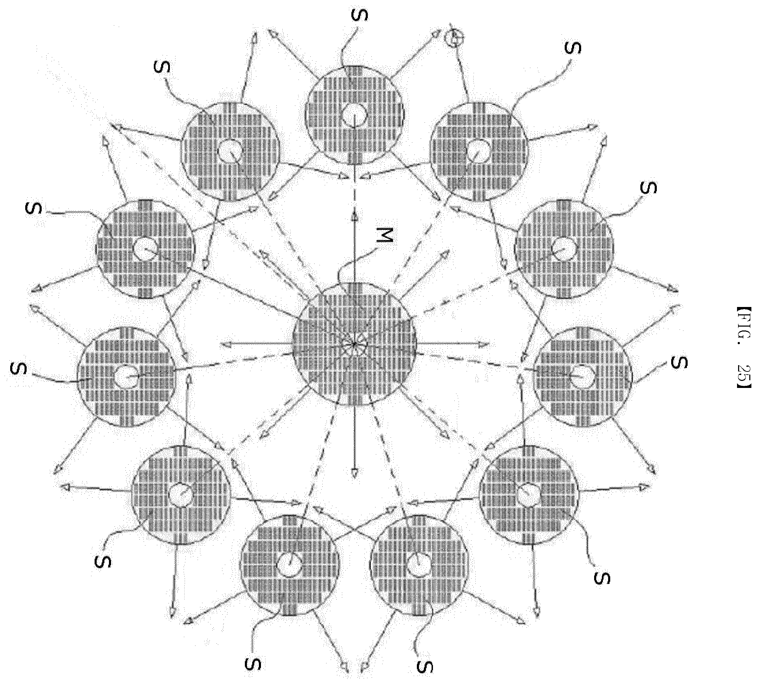

Meanwhile, the attached FIG. 25 shows another embodiment of the present invention in which small-capacity satellite power plants S are constructed around a large-capacity main power plant M and then the main power plant M and the satellite power plants S are connected by low-voltage underwater cables.

The satellite power plants S are configured to convert the generated DC power into AC power through an inverter and then transmit it to the main power plant M through underwater cables in a low-voltage state, and the main power plant M is configured to boost the low-voltage AC power transmitted from the satellite power plants and then transmit it to the power company through a high-voltage underwater cable.

In this case, although each of the satellite power plants S is constructed by successively connecting a central barge part 10 and unit buoyant parts 20, which are the same as the components of the main power plant M and described in the embodiment of the present invention, with interval maintaining bars 40, basic bars 22 and chains 23 and placing solar light modules 30 on the unit buoyant parts 20, the components thereof are configured to be smaller than those of the main power plant. In other words, the main power plant M and the satellite power plants S are anchored by a plurality of anchors 180 so that the movement thereof is suppressed. Pieces of power conversion equipment having different capacities are mounted on the main power plant M and the satellite power plants S.

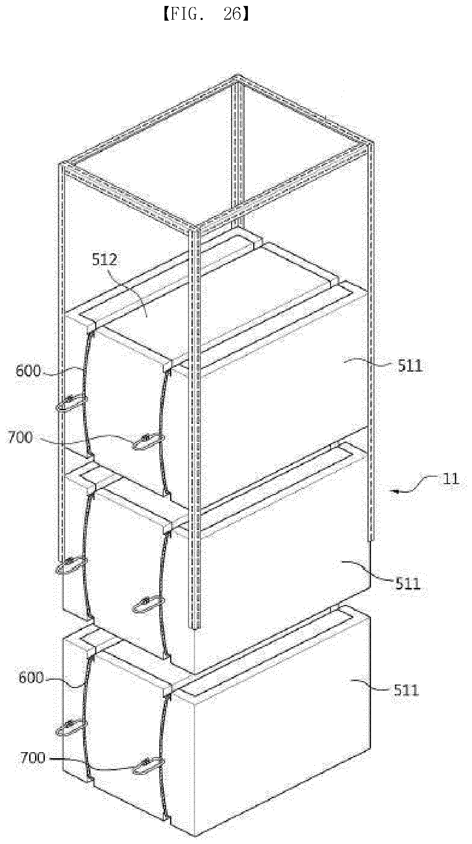

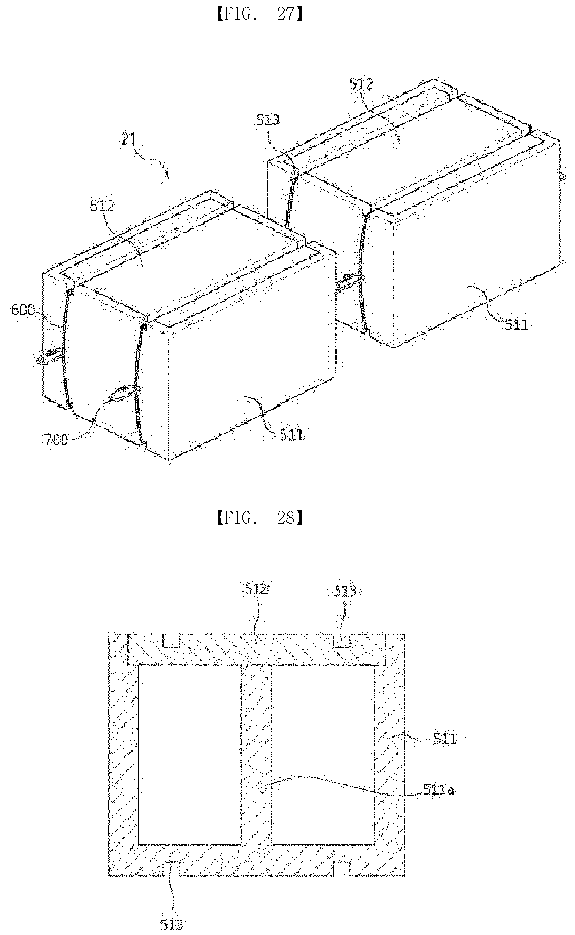

Meanwhile, as shown in the accompanying FIGS. 26 to 29, the first and second buoyant members 11 and 21 applied to the central barge part 10 and the unit buoyant part 20 may be configured to form concentric circles by binding a pair of binding strings 600 forming a ring shape to each buoyant member body 511 having partitions 511a configured to divide an internal space into a plurality of spaces and an open top surface and connecting the binding strings 600 of adjacent buoyant member bodies 511 with connecting strings 700 in a bundle form. In this case, the open top surface of the buoyant member body 511 is configured to be covered with a cover 512, and binding grooves 513 configured to allow the binding strings 600 each forming a ring shape to be bound are formed in the cover 512 and the bottom of the buoyant member body 511.

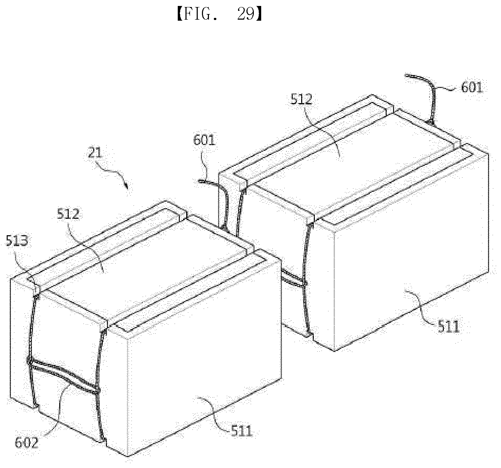

In this case, as shown in the accompanying FIG. 29, tied knot catch strings 601 and tied knot catch hooks 602 may be formed on the binding grooves 513 of the buoyant member bodies 511 constituting the first buoyant members 11, the tied knot catch strings 601 may be bound to the tied knot catch hooks 602, and the adjacent buoyant member bodies 511 may be bound to each other while forming concentric circles.

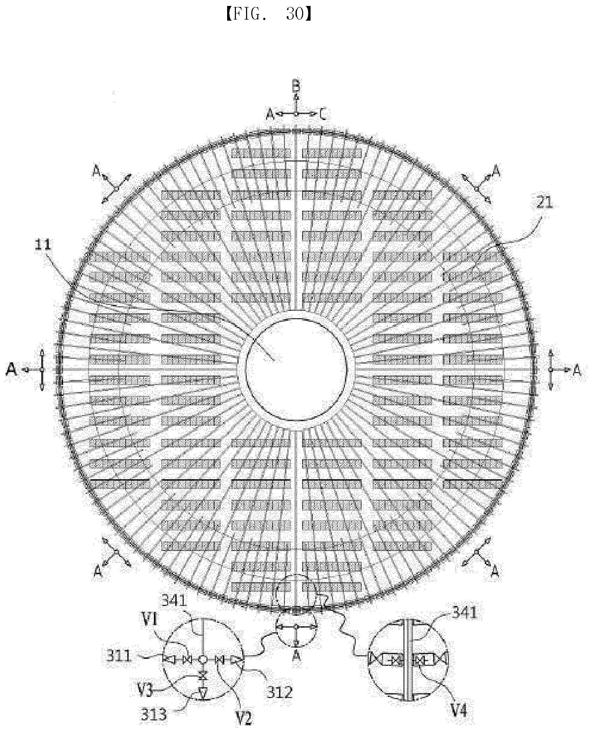

Meanwhile, as still another embodiment of the present invention, as shown in the accompanying FIG. 30, the second buoyant member 21 may be constructed by arranging a plurality of concentric circles, formed by connecting a plurality of buoyant member bodies 511 with the binding strings 600, at predetermined intervals and binding them with connecting rods 341 radially arranged, first, second and third spray propulsion nozzles 311, 312 and 313 configured such that the spraying of an air jet is controlled by valves V1, V2 and V3 through three-direction GPS location setting may be constructed at the ends of the connecting rods 341, the first and second spray propulsion nozzles 311 and 312 may be configured to spray air in order to track the sun, and the third spray propulsion nozzle 313 may be configured to spray air in order to move the second buoyant member 21.

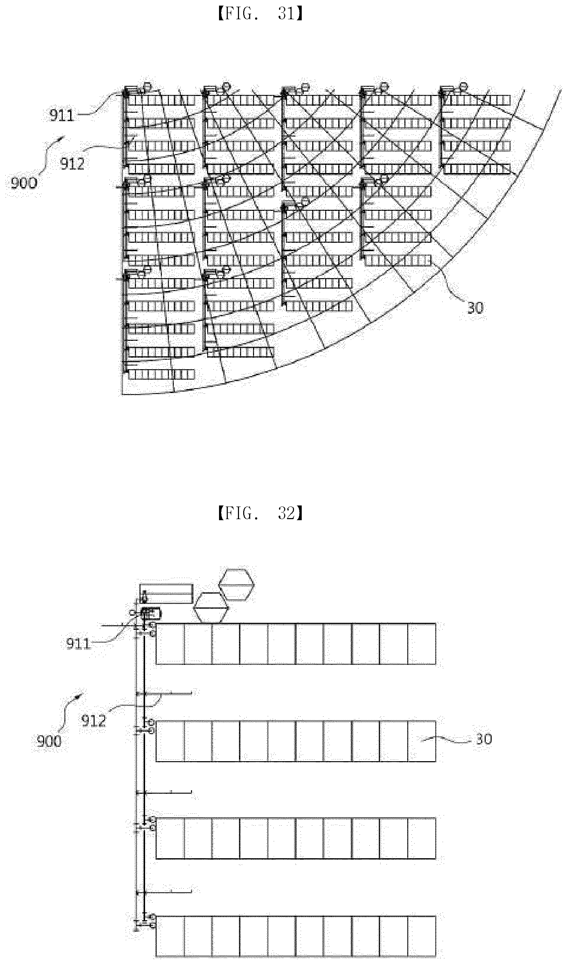

Furthermore, as still another embodiment of the present invention, as shown in the accompanying FIGS. 31 and 32, an air or water supply device 900 including a pump and/or a compressor 911 and a spray tube 912 and an air or water supply control valve V4 may be disposed in the second buoyant member 21 in order to spray air or seawater for the purpose of cooling the solar modules 30 or the removal of snow.

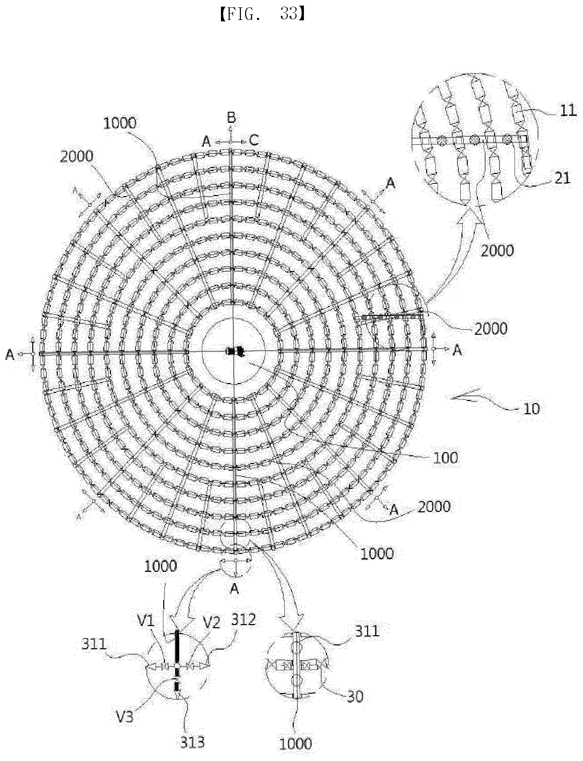

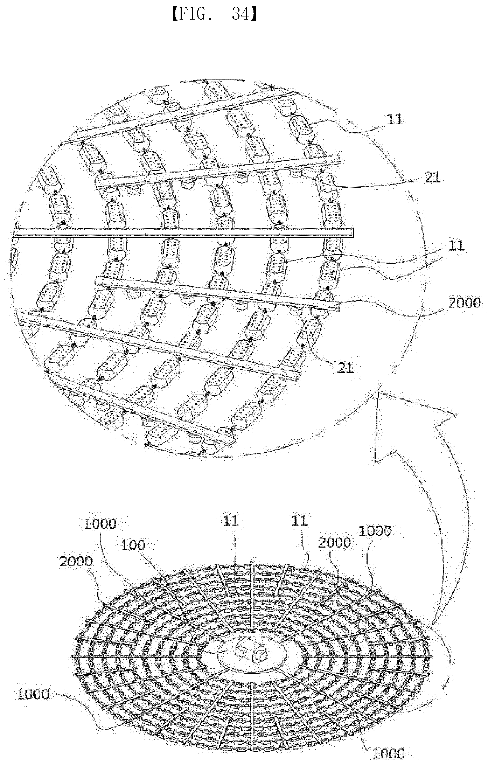

Meanwhile, the accompanying FIGS. 33 to 39 show still another embodiment of the present invention. In the following, like portions will be denoted by like symbols throughout the accompanying FIGS. 1 to 32 showing the embodiments of the present invention, and redundant descriptions thereof will be omitted.

In other words, in still another embodiment of the present invention shown in the accompanying FIGS. 33 to 39, in the state in which a central barge part 10 has been constructed, a basic frame 1000 that is floated by first buoyant members 11 which form concentric circles in a cross form and on which solar modules 30 are mounted is connected to the central barge part 10, auxiliary frames 2000 remaining at constant radial intervals are arranged between the basic frames 1000 forming concentric circles, and second buoyant members 21 are disposed on the auxiliary frames 2000.

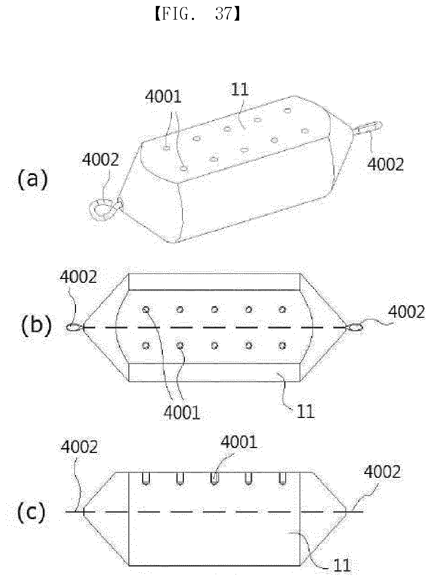

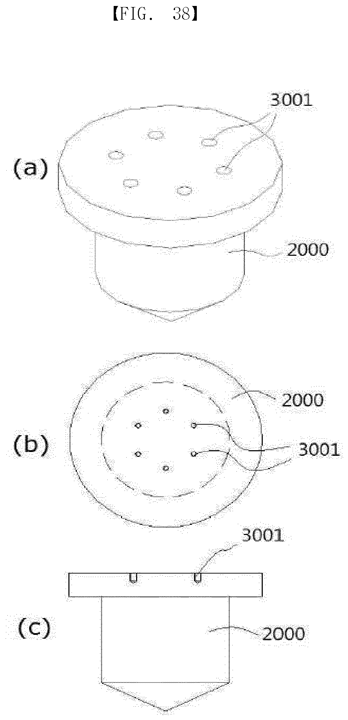

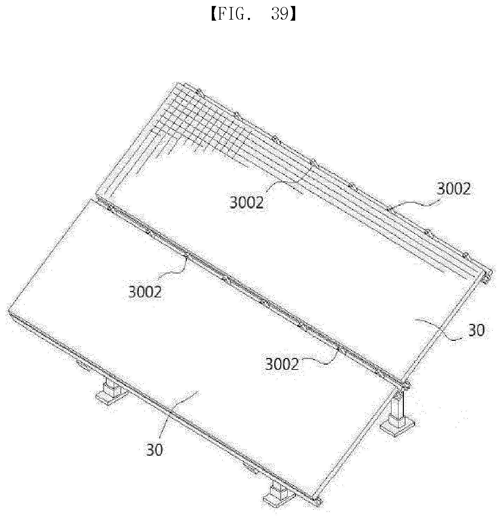

Fastening nuts 3001 are contained in the second buoyant member 21, as shown in the accompanying FIGS. 37 and 38, and a main supply tube 3002 for air or water supply configured to spray air or seawater for the purpose of cooling the solar module 30 or the removal of snow is disposed in each of the auxiliary frames 2000, as shown in the accompanying FIG. 39.

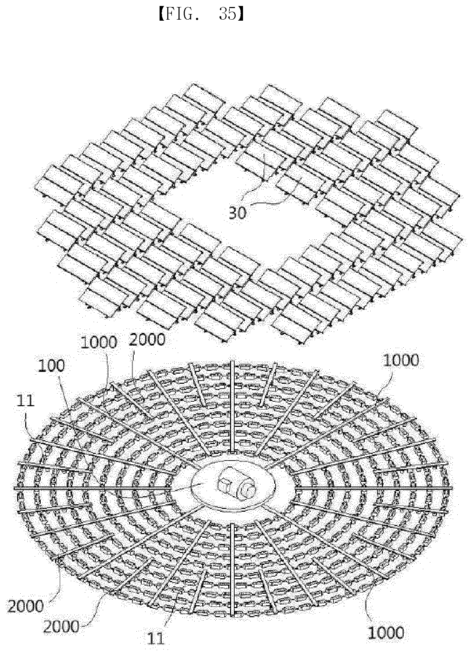

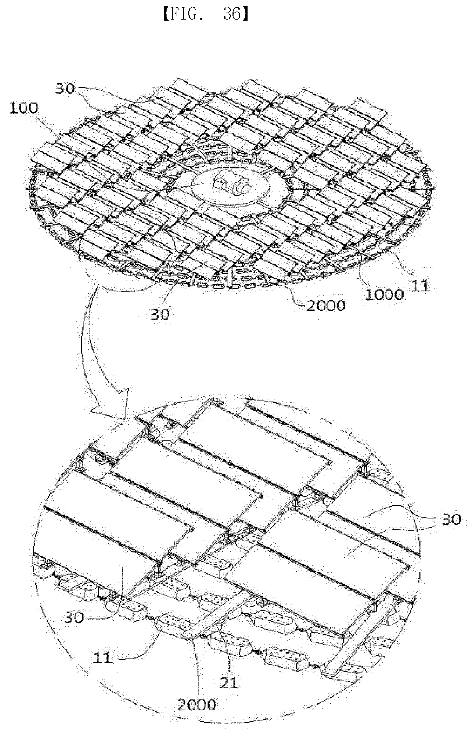

In this case, as shown in the accompanying FIGS. 35 and 36, fastening nuts 4001 and connecting rings 4002 are formed in the first buoyant member 11.

### Industrial Applicability

While the technical spirit for the tracking-type floating solar power generation device according to the present invention has been described in conjunction with the accompanying drawings above, this is intended to illustrate the most preferred embodiments of the present invention, but is not intended to limit the present invention.

Therefore, the present invention is not limited to the specific embodiments described above, and various modifications may be made by any person having ordinary skill in the art to which the present invention pertains without departing from the gist of the present invention as claimed in the claims. It will be apparent that such modifications fall within the scope of the claims.

## Claims

1. A tracking-type floating solar power generation device comprising:
a central barge part configured such that it is anchored by a plurality of anchors, containers in which first buoyant members are accommodated, respectively, are successively interconnected to each other so that power conversion equipment constituting a main power plant is mounted thereon, and perforated foot plates are placed on the successively connected containers, respectively; outer unit buoyant parts configured such that it is separated from the central barge part, forms concentric circles outside the barge part, and accommodates second buoyant members; and solar modules seated on the unit buoyant parts; thereby constituting an independent island structure;
wherein the unit buoyant parts forming concentric circles along with the central barge part are successively interconnected at constant intervals by interval maintaining bars disposed in parallel and chains;
wherein the unit buoyant parts are successively interconnected by basic bars disposed parallel with the interval maintaining bars and chains;
wherein a first drive unit configured to be operated to horizontally rotate and move the central barge part and the unit buoyant parts on a surface of water according to a location of a sun between the unit buoyant parts for which an interval between the concentric circles is kept constant by the interval maintaining bars;
wherein a second drive unit configured to be operated to adjust an inclined angle of the solar module according to an altitude of the sun is disposed on the basic bars; and
wherein the first and second drive units are configured such that operations thereof are controlled by a control unit configured to generate control signals for tracking of solar light for each time zone based on sunrise and sunset of the sun.

2. The tracking-type floating solar power generation device of claim 1, wherein connection rings are formed on outer circumferential surfaces of the containers, first catch hooks configured to successively interconnect the containers are coupled around and fastened to the connection rings, mouths are formed on top surfaces of the containers, coupling portions configured to surround the mouths are formed on bottom surfaces of the perforated foot plates, fastening rings configured to fasten the perforated foot plates are coupled to top surfaces of the containers, and the perforated foot plates are connected and coupled to adjacent upper foot plates by second catch hooks.

3. The tracking-type floating solar power generation device of claim 2, wherein the basic bars are constructed in a box-type structure to have a plurality of spaces in which second buoyant members are accommodated, connection rings configured such that the chains are coupled around them are disposed at both ends of the basic bars that constitute the box-type structure, and a first snap ring configured to be coupled around a corresponding one of the connection rings is disposed on any one of both ends of each of the chains.

4. The tracking-type floating solar power generation device of claim 3, wherein a connection ring and a second snap ring are disposed on one end of each of the interval maintaining bars to be coupled around a corresponding one of the chains that connect the unit buoyant parts.

5. The tracking-type floating solar power generation device of claim 4, wherein inclined-angle setting bars for a concentric circle extension section are additionally disposed at a changed angle at same points along with the basic bars disposed in parallel with the interval maintaining bars, thereby providing a new angle parallel bar reference.

6. The tracking-type floating solar power generation device of claim 1, wherein the first drive unit includes one or more first drive units that are disposed in a line between the unit buoyant parts that form the concentric circles.

7. The tracking-type floating solar power generation device of claim 6, wherein the first drive unit comprises:
a first motor configured to be rotated in a forward or reverse direction in response to a control signal of the control unit; and
one or more waterwheels connected to a drive shaft of the first motor, and configured to be rotated in response to the forward or reverse rotation of the first motor in order to horizontally rotate the central barge part and the unit buoyant parts on the surface of the water according to the location of the sun.

8. The tracking-type floating solar power generation device of claim 7, wherein fixed frames through which the drive shaft pass are coupled over the interval maintaining bars, and the waterwheels are coupled over the drive shaft that passes through the fixed frames.

9. The tracking-type floating solar power generation device of claim 6, wherein the first drive unit is configured such that a conveyor belt from a surface of which a plurality of flaps protrudes successively is installed in a caterpillar structure to be fastened below an operator movement foot plate, thereby ensuring that a moving space of an operator is secured by removing unnecessary structures protruding upward and also effectively preventing occurrence of reverse torque by generating propulsion force under the surface of the water.

10. The tracking-type floating solar power generation device of claim 9, wherein the first drive unit formed in a shape of conveyor belts forming caterpillars has a fastening bracket configured to perform fastening under the operator movement foot plate while maintaining a predetermined distance, a plurality of cylindrical drums configured such that buoyancy thereof is adjustable through injection of air is disposed at lower ends of the fastening bracket, conveyor transfer protrusions protrude from a surface of the cylindrical drums, outsides of the cylindrical drums are surrounded with the conveyor belts, each of the conveyor belts is configured such that a plurality of connection plate members on which the individual flaps are disposed is spaced apart at predetermined intervals, and the spaced, adjacent connection plate members are combined by fastening rings, so that spaces in which the conveyor transfer protrusions formed on the surface of the cylindrical drum are placed are provided in connection portions of the fastening rings.

11. The tracking-type floating solar power generation device of claim 10, wherein a forward/reverse rotation motor coupled to a drive gear and connected to a reducer through a transfer gear is disposed on one side of a center-of-rotation shaft of any one of the pair of cylindrical drums located both left and right ends.

12. The tracking-type floating solar power generation device of claim 10, wherein an extension bracket is disposed at a lower end of the fastening bracket fastened under the operator movement foot plate and configured to support the plurality of cylindrical drums, and deflection preventing rollers are disposed on lower ends of the extension bracket in order to prevent downward deflection of a corresponding one of the conveyor belts each formed by connecting the plurality of connection plate members.

13. The tracking-type floating solar power generation device of claim 10, wherein the individual flaps disposed outward on surfaces of the conveyor belts are disposed to have a width smaller than that of the conveyor belts, and deflection preventing rollers are located in a flap-free section in which the individual flaps are not located in order to prevent downward deflection of the conveyor belts.

14. The tracking-type floating solar power generation device of claim 1, wherein the second drive unit comprises:
a horizontal fastening part disposed on the basic bars;
a vertical fastening part configured to connect the horizontal fastening part and a front side of each of the solar modules;
a cylinder part coupled and fastened to a rear side of the horizontal fastening part;
an angle adjusting bar connected to a moving element configured such that one end thereof is connected to the solar module and a remaining end thereof is accommodated inside the cylinder part and configured to adjust an inclined angle of the solar module while being selectively lifted and lowered by the moving element; and
an altitude tracking buoyant element configured to be accommodated in a lower end of an inside of the cylinder part and to, when supply or discharge of water to or from the cylinder part is performed in response to a control signal of the control unit, be selectively lifted and lowered and selectively lift and lower the moving element.

15. The tracking-type floating solar power generation device of claim 1, wherein the second drive unit comprises:
a horizontal fastening part disposed on the basic bars;
an X bar configured to connect the horizontal fastening part and the solar module; and
a second motor connected to a shaft connecting the X bar, and configured to be operated in response to a control signal of the control unit in order to adjust the inclined angle of the solar module by rotating the shaft.

16. The tracking-type floating solar power generation device of claim 1, wherein:
the first and second buoyant members are configured to form concentric circles by binding a pair of binding strings to each buoyant member body and connecting the binding strings of the buoyant member bodies with connecting portions of adjacent buoyant member bodies in a bundle form; and
the second buoyant member is constructed by arranging a plurality of concentric circles, formed by connecting a plurality of buoyant member bodies with the binding strings, at predetermined intervals and binding them with connecting rods radially arranged, first, second and third spray propulsion nozzles configured such that spraying of an air jet is controlled by valves through three-direction GPS location setting are constructed at ends of the connecting rods, and the third spray propulsion nozzle is configured to spray air in order to move the second buoyant member.

17. The tracking-type floating solar power generation device of claim 16, wherein the binding strings are a pair of binding strings that form a ring shape, and the connection portions are connecting strings that are bound to the pair of binding strings forming a ring shape.

18. The tracking-type floating solar power generation device of claim 16, wherein the binding strings are tied knot binding strings that are bound to the buoyant member bodies, and the connection portions are catch hooks that are formed when the tied knot binding strings are bound to the buoyant member bodies.

19. The tracking-type floating solar power generation device of claim 16, wherein the buoyant member body is configured to have an internal column portion and an open top surface, the open top surface of the buoyant member body is configured to be covered with a cover, and binding grooves configured to allow the binding strings each forming a ring shape to be bound are formed in the cover and a bottom of the buoyant member body.

20. The tracking-type floating solar power generation device of claim 16, wherein an air or water supply device including a pump and/or a compressor and a spray tube is disposed in the second buoyant member in order to spray air or seawater to cool the solar module or remove snow.

21. The tracking-type floating solar power generation device of claim 1, wherein when a floating solar light power plant having an independent island structure is set as a large-capacity main power plant, small-capacity satellite power plants, each including a central barge part, unit buoyant parts, and solar modules, are located around the large-capacity main power plant and the large-capacity main power plant and the small-capacity satellite power plants are connected with low-voltage underwater cables.

22. The tracking-type floating solar power generation device of claim 21, wherein the satellite power plants are configured to convert generated DC power into AC power through an inverter and then transmit it to the main power plant through underwater cables in a low-voltage state, and the main power plant is configured to boost the low-voltage AC power transmitted from the satellite power plants and then transmit it to a power company through a high-voltage underwater cable.

23. The tracking-type floating solar power generation device of claim 21, wherein anchors configured to fasten a location of a power plant against a typhoon or another situation are disposed on the central barge parts of the main power plant and the satellite power plants.

24. The tracking-type floating solar power generation device of claim 23, wherein each of the anchors is configured to be connected to a thick wire rope having a predetermined length and drooping to a floor, and the wire rope is configured to be bound to the central barge part in an emergency and to be connected to a thin lifting rope at a remaining end thereof during normal times to minimize water resistance while maintaining drooping.

25. The tracking-type floating solar power generation device of claim 23, wherein each of the plurality of anchors includes a plate-shaped fastening body formed by coupling a plurality of ring members based on connection bars radially connected to each other, a central weight insertion rod located at a center and a plurality of counterweight insertion rods spaced apart around the central weight insertion rod, which are installed to selectively couple a required number of weights, are installed to protrude upward along a surface of the fastening body, and bottom surface fastening wedge portions are formed on bottoms of the central weight insertion rod and the counterweight insertion rods.

26. The tracking-type floating solar power generation device of claim 1, wherein a basic frame is connected to the central barge part in a cross form, and the first buoyant members forming the concentric circles are successively disposed on the basic frame;
auxiliary frames remaining at constant radial intervals are arranged between the basic frames forming concentric circles; and
second buoyant members are disposed on the auxiliary frames.

27. The tracking-type floating solar power generation device of claim 26, wherein a main supply tube for air or water supply configured to spray air or seawater in order to cooling the solar module or remove snow is disposed in each of the auxiliary frames.

28. The tracking-type floating solar power generation device of claim 1, wherein:
a wire guide tube configured to guide an anchor cable is disposed on outsides of the containers containing the first buoyant members in order to maintain a stable buoyant posture of the central barge part;
guide rollers are disposed at upper and lower ends of the wire guide tube; and
a wire tension adjusting traction machine is disposed above the wire guide tube.

29. The tracking-type floating solar power generation device of claim 14, wherein:
upper and lower water tanks are successively disposed at a predetermined interval along a boundary surface of the central barge part and the unit buoyant parts disposed outside the barge part while forming concentric circles, the upper and lower water tanks are disposed to form a stack structure in which the upper and lower water tanks are disposed above and below a boundary surface of a water of the central barge part and the unit buoyant parts disposed outside the barge part, and the upper and lower water tanks having respective shutoff valves are connected to a single circulation pipe and then connected to a plurality of altitude tracking cylinder parts;
when the valve of the upper water tank is opened, water of the upper water tank disposed above the surface of the water is discharged by natural water pressure and fills the cylinder part disposed on an outer side, and thus a slope of the solar module is adjusted to an erected state; and
when the valve of the lower water tank is opened, the water filling the cylinder part is naturally discharged to the lower water tank located below the surface of the water, the water of the cylinder parts is discharged to the lower water tank, and thus the slope of the solar module is adjusted to a laid state.

30. The tracking-type floating solar power generation device of claim 29, wherein the water discharged to the lower water tank is forcibly pumped to the upper water tank so that the upper water tank always remains in a filled state.
